(19) Europäisches Patentamt / European Patent Office / Office européen des brevets

(11) **EP 4 187 787 A1**

(12) **EUROPEAN PATENT APPLICATION**

(43) Date of publication:
**31.05.2023 Bulletin 2023/22**

(21) Application number: **21210742.9**

(22) Date of filing: **26.11.2021**

(51) International Patent Classification (IPC):
**H03K 17/082** $^{(2006.01)}$

(52) Cooperative Patent Classification (CPC):
**H03K 17/0822; H03K 17/0824;** H03K 2217/0027

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **ECOLE POLYTECHNIQUE FEDERALE DE LAUSANNE (EPFL)**
**1015 Lausanne (CH)**

(72) Inventors:
• **Dujic, Drazen**
 **1092 BELMONT-LAUSANNE (CH)**
• **Li, Chengmin**
 **1004 LAUSANNE (CH)**

(74) Representative: **Banse & Steglich**
**Patentanwälte PartmbB**
**Patentanwaltskanzlei**
**Herzog-Heinrich-Straße 23**
**80336 München (DE)**

(54) **PROTECTION UNIT FOR WIDE BANDGAP POWER SWITCHING DEVICE AND METHOD FOR OPERATING THE WIDE BANDGAP POWER SWITCHING DEVICE**

(57) The invention relates to a method for operating a power switching device, particularly a wide bandgap power switching device, in a power application, particularly in a converter, comprising the steps of:
- checking (S2) a transient voltage of or related to a voltage drop across the switching device (22, 23) against a predetermined first threshold ($V_{ref1,UP}$, $V_{ref1,LOW}$) ;
- reducing (S3) conductivity of the switching device (22, 23) if it is determined that the value of the transient voltage exceeds the predetermined first threshold ($V_{ref1,UP}$, $V_{ref1,LOW}$);
- after reducing the conductivity, checking (S4) the voltage drop across the switching device (22, 23);
- deactivating (S5) the operation of the switching device (22, 23) if it is determined that the voltage drop is larger than a predetermined second threshold ($V_{ref2,UP}$, $V_{ref2,LOW}$).

Fig. 1

## Description

Technical field

The present invention relates to wide bandgap switching devices for use in power electronic converters for electrical energy processing. Particularly, the present invention deals with a short-circuit protection of such switching devices.

Technical background

Power electronic converters are widely used to convert one type of electricity to another or to generally assist in energy generation or conversion. Often, the application of power electronic converters requires a reliable and efficient operation without interruption or downtimes. Power switching devices are critical components in the power electronic converters as they are directly exposed to power processing. Significant energy losses occur in power switching devices mainly at high-frequency switching due to conduction losses and non-ideal switching characteristics of the switching devices. Therefore, it is important to reduce the power losses of the power switching devices to achieve a better performance of power electronic converters.

Conventionally, silicon-based power switching devices have reached a performance close to their physical limits so that further technological improvements are expected to be incremental. As next-generation power switching devices, wide bandgap switching devices, such as switching devices based on silicon carbide (SiC) or gallium nitride (GaN), are gradually entering the field of power electronics applications. Compared to silicon power switching devices, wide bandgap switching devices are even more suited for high voltage, high frequency and high temperature applications. Therefore, power electronic converters using wide bandgap switching devices will typically profit from these properties.

While these wide bandgap switching devices offer improved conversion efficiency compared to state-of-the-art silicon switching devices, they also require significantly different protection schemes acting much faster and/or providing protection in a shorter amount of time. During the operation of power electronic converters, there are various stress factors that affect the operational performance, such as electrical, thermal and mechanical factors. In a conventional well-known voltage source converter, a short circuit may cause a destructive failure of the converter which implies a short circuit of the DC link capacitors where a significant amount of energy is stored. This energy is subsequently dissipated as heat in the switching devices causing high damage.

Owing to wide bandgap characteristics, the chip size of the power switching devices can be made much smaller than that of silicon devices which makes it more difficult to quickly dissipate the heat from the switching devices' chip. Furthermore, after the occurrence of a short-circuit event, the short-circuit current through the wide bandgap switching devices is significantly higher compared to a short-circuit current through the conventional silicon switching devices. This leads to a far higher heat generation in the wide bandgap switching devices which essentially reduces the survivable short-circuit time of wide bandgap switching power devices. For instance, the survivable short-circuit time of wide bandgap switching power devices may be less than 3 μs compared to that of silicon devices which is normally about 10 μs.

A common mean for short-circuit protection is the use of desaturation detection circuits as known from V. John et al., "Fast-clamped short-circuit protection of IGBT's," in IEEE Transactions on Industry Applications, vol. 35, no. 2, pp. 477-486, March-April 1999 and R. Chokhawala et al., "IGBT fault current limiting circuit," Conference Record of the 1993 IEEE Industry Applications Conference Twenty-Eighth IAS Annual Meeting, 1993, pp. 1339-1345, vol. 2. The strategy is to sense the voltage drop during the conduction of the switching devices to detect the short-circuit fault. If such a fault has been detected, the device is turned off with a soft-off circuit. The operation principle is to monitor the on-state voltage across the power switching device and to compare it with a preset threshold value. During the normal operation, the voltage drop is relatively small and unable to trigger the protective reaction. In case of a short circuit which is detected by an increased voltage drop across the switching device, the switching device will be turned off. To avoid the overshoot voltage during the turn-off, a soft turn-off is applied by reducing the turn-off speed with an increased turn-off resistor or the decreased gate driving voltage. Another implementation of a short-circuit protection is using a shunt resistor for current sensing, so that a voltage drop over the shunt resistor directly reflects the current passing through the power switching device.

As known from P. Hofstetter et al., "Applying the 2D-Short Circuit Detection Method to SiC MOSFETs including an advanced Soft Turn Off," PCIM Europe 2018; International Exhibition and Conference for Power Electronics, Intelligent Motion, Renewable Energy and Energy Management, 2018, pp. 1-7 a series-connected inductor can be applied between the Kelvin terminal and the power terminal so that when a short circuit occurs, an induced voltage across the leakage inductor is generated. By detecting the peak voltage, a short-circuit event can be identified causing the device to be turned off.

As known from S. Yuvarajan et al., "Performance analysis and signal processing in a current sensing power MOSFET (SENSEFET)," Conference Record of the 1991 IEEE Industry Applications Society Annual Meeting, 1991, pp. 1445-1450 vol.2 and K. Han et al., "1.2-kV 4H-SiC SenseFET With Monolithically Integrated Sensing Resistor," in IEEE Electron Device Letters, vol. 41, no. 3, pp. 437-440, March 2020, an integrated current sensor may be designed in that the power switching device, so that when a short-circuit event occurs, the voltage across the sensor increases together with a voltage across the switching device so that a short circuit can be detected.

Furthermore, a short-circuit current can be measured using a Rogowski coil on the primary side of a single turn transformer. On the secondary side of the transformer, an induced voltage can be monitored in the value which is an indication of the current flowing through the device.

Conventional methods and circuitry for short-circuit protection that exist for silicon power switching devices, however, have in common that they are not reacting fast enough to be directly applied for wide bandgap power switching devices. Therefore, it is an object of the present invention to provide a reliable short-circuit protection of the converter applying wide bandgap power switching devices.

Summary of the invention

According to the invention, a protection unit for a wide bandgap power switching device according to claim 1 and a power electronics converter using wide bandgap switching devices according to the further independent claim are provided.

Further embodiments are indicated in the depending subclaims.

According to a first aspect, a method for operating a power switching device, particularly a wide bandgap power switching device, in a power application, particularly in a converter, is provided, comprising the steps of:

- checking a transient voltage of a voltage drop across the switching device against a predetermined first threshold;
- reducing conductivity of the switching device if it is determined that the value of the transient voltage exceeds the predetermined first threshold;
- checking the voltage drop across the switching device;
- deactivating the operation of the switching device if it is determined that the voltage drop is larger than a predetermined second threshold.

Particularly, reducing conductivity of the switching device may be made by selectively turning-on a resistance between a gate and a source terminal of the power switching device.

In general, power switching devices have a limited operating range with respect to their junction temperatures. Power losses are generated in the power switching device due to conduction of an electric current which causes a voltage drop across the switching device. The power losses result in heat generation in the device. Usually, the power electronics converter in which the power switching device is applied is configured up so that the junction temperature during a normal operation securely remains in the operation range. As to the normal operation, the power losses in the switching device are relatively low, as the switching device operates in its ohmic region and the voltage drop across the switching device is relatively small. The generated heat is considered in the design phase and is properly dissipated by means of an appropriate cooling system.

When the forward current from the switching device is higher than a certain limit, the switching device enters the saturation region and a relatively high voltage drop occurs across the switching device resulting in a significant increase of heat generation. This may quickly lead to the increase of the device temperature beyond the limits of the secure operation range. Overcurrents through the switching device, which may imply the risk of pulling the switching device into the saturation operation, can usually be detected easily when they occur during the normal operation of the power electronics converter.

However, overcurrents also can occur caused by a short circuit resulting in a quick increase of the forward current through the switching device which requires an immediate and quick turning off of the circuitry, particularly by turning off the voltage supply over the switching device. While conventional short-circuit protection circuits may turn off the voltage supply over the switching devices in a sufficiently low time after detection of the short circuit, the reaction time may be not low enough to protect converters using wide bandgap power switching devices made of silicon carbide or gallium nitride.

In a conventional power electronics converter, the power switching devices are usually interconnected as inverters having an upper leg and a lower leg connected to a DC link / DC bus wherein AC terminals are connected to a load or an AC supply. Short-circuit events may occur due to different reasons wherein the causes may be distinguished by four types as follows:

1. Short circuit of the DC link, when two switching devices in the same phase leg conduct at the same time. Typical reasons for such a short circuit are a false gate driving signal or a crosstalk interference. The crosstalk voltage on the device is the interference voltage introduced by the switching of the other switching device due to the parasitic coupling between the gate loop and the power loop. The occurrence of such an event is more likely with SiC devices due to extremely high transient voltage during switching. In case of a short circuit, the supply voltage will directly add to the two switching devices in series, causing a huge current to flow through the device.

2. Short circuit of the phase leg output to positive or negative DC bus lines. Due to the failure of the insulation of the system or the other faults, the output terminal is connected to the DC bus. In this case, the whole DC bus voltage drops over the conducting switching device immediately, causing saturation of the switching devices. The device current will rise to the saturation region quickly and cause huge power loss in a short period of time, leading to the destruction of the device.

3. Phase-to-phase short circuit when the outputs of the inverters are electrically connected. Here, the DC bus voltage drops over a series connection of one of the switching devices in one phase and one of the switching devices of another phase leg. The voltage stress will be shared between the two switching devices in different phase legs.

4. Phase-to-ground short circuit, when the output inductor is bypassed and the current is returned to the DC link under certain configurations. Such fault type is not common but happens when one terminal of DC bus is connected to the ground and there exists ground fault on the AC output of the phase leg. The DC bus voltage then drops over the switching device directly.

All of these short-circuit events may cause serious damage to the switching devices if they are not turned off in a significantly short period of time to protect the semiconductor from high-temperature damage. Therefore, when a short-circuit event occurs, detection should be made as fast as possible to allow a quick turn-off reaction. Furthermore, the detection of a short-circuit event should be made robust and immune against noise to avoid a false protection reaction.

The fast switching of wide bandgap power switching devices increases the challenges for the protection circuitry. The protection circuit according to the present invention can be applied to any half-bridge phase leg of a converter having one or multiple phase legs, e.g. a bridge/inverter circuitry or of an H-bridge or of a B6-bridge topology. The phase leg comprises two power switching devices in series with a positive and a negative terminal connected to a DC bus capacitor, while an intermediate node of the phase leg being connected to an external circuit (e.g. load). Usually, the upper power switching device and the lower power switching device are controlled to switch intermittently to generate an AC square wave voltage at the intermediate node. The proposed protection circuity is usually adapted to detect the conditions on the intermediate node.

According to the above method, to detect and react on a short-circuit event, firstly, the transient voltage / voltage gradient is detected preferably as a voltage at the intermediate node / output terminal by a transient voltage (dv/dt) sensing means. If it is determined that the voltage gradient is higher than a certain first threshold, it can be viewed as the possible indicator of a short-circuit event inside the circuitry (phase leg). Then, the gate-source voltage of the power switching device in the phase leg which is turned on (on-state = high conductivity) is reduced, i.e. gate-source voltage is set to a lower value to limit the current passing through the switching device.

Secondly, with a relatively slower speed, the voltage drop across the switching device is sensed (measured) and compared to a given second threshold. If the sensed voltage drop exceeds a pre-defined acceptable value, the switching device will be turned off under the control of a gate driver. Moreover, if it is determined that the voltage drop is lower than a predetermined second threshold, the reduction of the conductivity of the switching device may be released.

Meanwhile, if there is no short circuit detected by the voltage drop in the second step, the gate-source voltage reduced in the first step will be released, and normal operating conditions will be restored.

It may be provided that the second threshold is defined depending on the saturation voltage of the power switching device, which may depend on the gate-source voltage minus the threshold voltage of the the power switching device. A certain amount of margin may be required considering the noise interference.

It may further be provided that the switching device is only turned off if it is determined within a given time period that the voltage drop is larger than the predetermined second threshold.

In a converter application, it may be provided that the common error signal (E) is only provided if it is determined that the detection of the transient voltage of or related to the voltage drop across the switching device being larger than the predetermined first threshold and the detection that the voltage depending on the voltage drop across the power switching device being larger than the given second threshold is made during an on-state condition of the power switching device.

The use of the transient voltage sensing means allows a significant increase of the detection sensitivity, as the detection of a transient voltage generally has a much faster response speed. However, as the judging of the short circuit only based on the transient voltage may not be reliable enough as in converter applications, the short circuit may also occur in other phase legs which also introduces a voltage dip or spike in the AC voltage at the intermediate node of the other phase legs.

Furthermore, the transient voltage sensing means is very sensitive to a random noise in the converter circuitry. As a consequence, once a high transient voltage is detected, the gate-source-voltage is temporarily clamped to a lower value, e.g. by means of a clamping circuit to limit the saturation current of the power switching device. As a result, the short-circuit withstanding time is increased, as the power dissipated in the power switching device is lower, thereby generating less heat. By applying the voltage sampling means, the increased voltage drop over the power switching device in case of the short-circuit event can be detected once the voltage sampling means detects the increased voltage drop over the guarded power switching device, the short-circuit event is confirmed and the power switching device is turned off directly. Since the gate-source voltage has been decreased in advance in the first step, the soft turn-off is guaranteed and no extra soft turn-off circuit is required.

Another important consideration occurs on how to properly break the large current, once it is established and detected, to avoid avalanche breakdown of the power device. During turn-off, there will be a large current slope, which introduces large voltage spike over the power switching device, and this overvoltage should not be exceeding device voltage ratings. The above short-circuit protection should be able to limit the over-voltage during turn-off process. Considering these challenges, this invention hereafter proposes a new solution that can be applied to all the mentioned types of the short-circuit protection of power switching devices, especially for wide bandgap power switching devices, such as SiC power semiconductors.

According to a further aspect, a protection unit for protecting a power switching device against a short-circuit event is provided, comprising:

- A transient voltage sensing means configured to check a transient voltage of or related to a voltage drop across the switching device against a predetermined first threshold;
- a clamping circuit configured to reduce conductivity of the power switching device, particularly for a given time period, if it is determined that the transient voltage of the voltage drop across the switching device is larger than the predetermined first threshold;
- a voltage sampling means configured to sample a voltage depending on a voltage drop across the power switching device after reduction of the conductivity;
- an error signal generating means to provide a common error signal if it is determined that the transient voltage of the voltage drop across the switching device is larger than the predetermined first threshold and if it is determined that a voltage depending on a voltage drop across the power switching device is larger than a given second threshold.

Furthermore, the transient voltage sensing means may be formed with a transient voltage sensing unit, particularly a high-pass filter, and/or the voltage sampling means may be implemented with a voltage sampling unit particularly with a low-pass filter.

According to an embodiment, the error signal generating means may be configured to provide the common error signal only if it is determined that the detection of the transient voltage of the voltage drop across the switching device being larger than the predetermined first threshold and the detection that the voltage depending on the voltage drop across the power switching device being larger than the given second threshold is made during an on-state condition of the power switching device.

Furthermore, a first comparator may be provided to check if the transient voltage of the voltage drop across the switching device is larger than the first threshold, wherein a pulse generator is provided to generate a pulse for a clamping signal with a predetermined minimum pulse duration for controlling the clamping circuit as a result of the checking of the first comparator.

According to a further aspect, a power converter is provided, comprising:

- At least one phase leg comprising at least two power switching devices in series;
- a protection circuit according to any of the claims 7 to 9 for each of the power switching devices;
- a gate driver for each of the power switching devices configured to control the power switching devices according to a given switching control scheme and to deactivate switching of the respective power switching device depending on the common error signal.

The transient voltage sensing means and the voltage sampling means may be coupled with an intermediate node between two of the power switching devices.

Moreover, the transient voltage sensing unit of the transient voltage sensing means and the voltage sampling unit of the voltage sampling means may be shared for each of the power switching devices of one phase leg.

Brief description of the drawings

Embodiments are described in more detail in conjunction with the accompanying drawings, in which:

Figure 1     shows an exemplary power electronics converter applying power switching devices in three-phase half bridge configuration;

Figure 2     shows the circuitry of a phase leg including a protection circuit for both the upper power switching device and the lower power switching device;

Figure 3     shows the circuitry of a phase leg with detailed circuitry of the voltage sampling means and the transient voltage sensing means;

Figure 4     shows the circuitry of a phase leg with detailed circuitry of the voltage sampling means and the transient voltage sensing means;

Figure 5     shows a flowchart illustrating the operation method of the protection unit;

Figure 6     shows a signal time diagram indicating the gate source voltage, the forward current, the node voltage, the clamping gate voltage and the common error signal in case a short-circuit event occurs; and

Figure 7   shows a signal time diagram indicating the gate source voltage, the forward current, the node voltage, the clamping gate voltage and the common error signal in case a false short-circuit triggering occurs during the first step of transient voltage sensing.

Detailed description of embodiments

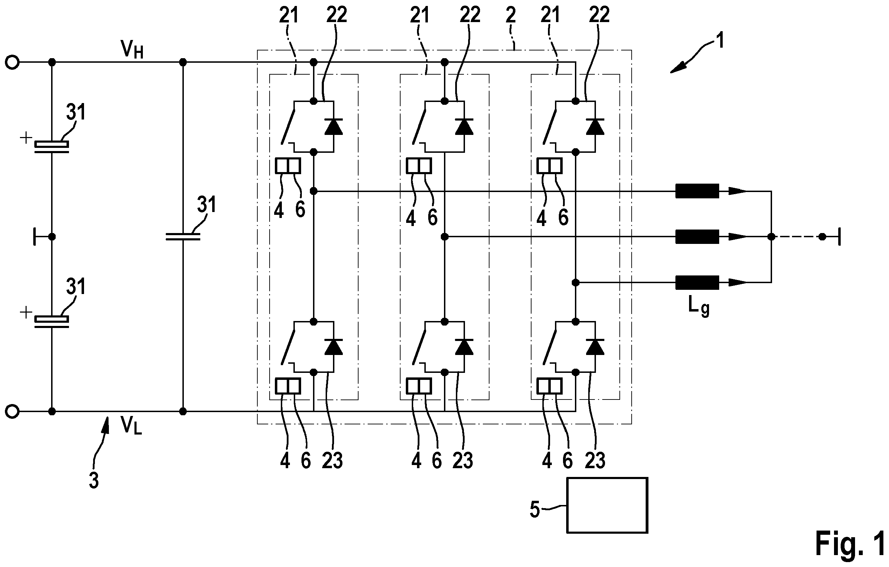

Figure 1 schematically shows an exemplary power converter 1 with a three-phase converter stage 2 having a DC power bus 3 supplying a high voltage potential $V_H$ and a low voltage potential $V_L$. The DC power bus 2 is buffered by DC link capacitors 31. Between the high voltage potential $V_H$ and the low voltage potential $V_L$, three phase legs 21 each formed as an inverter circuit are coupled in parallel to provide a three-phase AC output. Each phase leg 21 has an upper power switching device 22 and a lower power switching device 23 which are serially interconnected and in between which an intermediate node N is formed to provide an AC terminal.

Each of the power switching devices 22, 23 may be coupled with an individual gate driver 4 which is under control of a control unit 5 to operate the switching of the switching devices 22, 23 of each phase leg 21. The gate driver 4 may include or be coupled with a protection unit 6 to provide a protection against a short-circuit event.

The power switching devices 22, 23 may be provided as gate-commutated thyristors or a MOSFET particularly configured as a wide bandgap switching device, such as made with silicon carbide or gallium nitride as the active semiconductor material. Here, the power switching devices 22, 23 are depicted with a simple switch symbol coupled in parallel with an anti-parallel diode.

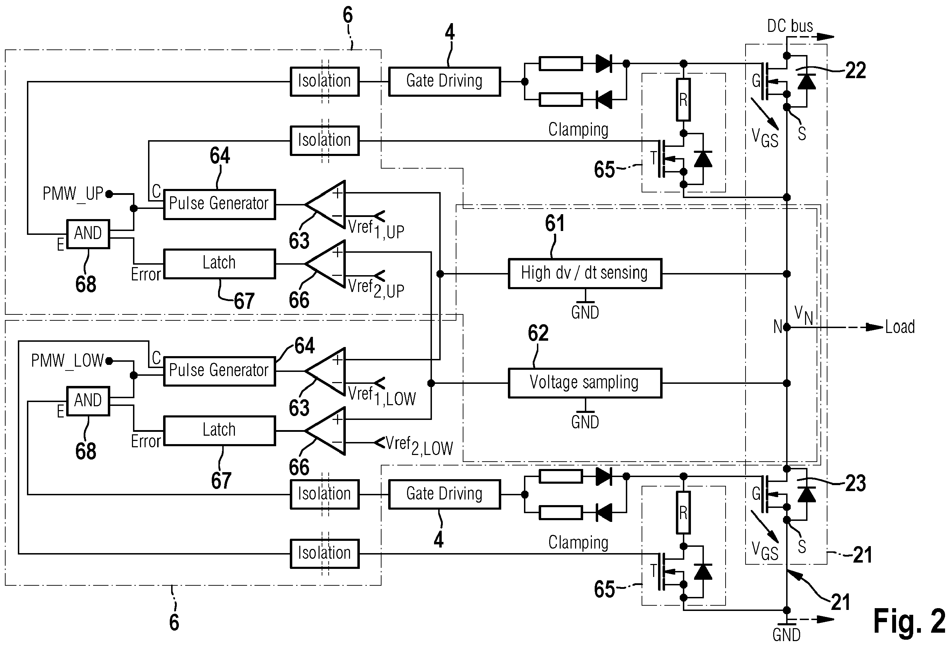

Figure 2 shows the protection unit 6 for the upper power switching device 22 and the lower power switching device 23 of one of the phase legs 21 in more detail.

As can be seen in Figure 2, the intermediate node N of the phase leg 21 is coupled with a transient voltage sensing unit 61 of a transient voltage sensing means which taps a voltage gradient dv/dt of the intermediate node voltage $V_N$. Basically, the transient voltage sensing unit 61 may be implemented with a high-pass filter.

Furthermore, a voltage sampling unit 62 of a voltage sampling means is coupled with the intermediate node N to measure the intermediate node voltage $V_N$ at the intermediate node N of the phase leg 21.

The transient voltage sensing unit 61 and the voltage sampling unit 62 can be provided for each protection unit 6 separately or, as shown in Figure 2, can be shared for the protection units 6 for the upper and lower power switching device 22, 23.

The output of the transient voltage sensing unit 61 is a value indicating the timely gradient which is fed to a respective first comparator 63 for the upper power switching device 22 and the lower power switching device 23, respectively. Once, a high voltage gradient exceeding a given gradient of a first threshold $V_{ref1,UP}$ or $V_{ref1,LOW}$, respectively, has been detected by the first comparator 63, a pulse generator unit 64 is triggered to generate a clamping signal to temporarily turn on a clamping circuit 65. The transient voltage sensing unit 61, the first comparator 63 and the pulse generator form a transient voltage sensing means. The clamping circuit 65 is coupled with the gate G and source S terminals of the respective power switching device 22, 23 to selectively reduce the gate-source-voltage. This allows limiting the forward current passing through the respective power switching device 22, 23 when the clamping circuit 65 is activated. The clamping signal C is formed as a pulse having a predetermined minimum pulse duration which is set so that the pulse may indicate that the condition of the too high transient voltage is fulfilled at the time the voltage sampling unit 61 and the second comparator 66 detect the too high voltage drop over the on-state switching device 22, 23. Particularly, the minimum pulse duration of the pulse should be slightly larger than the short-circuit time of the switching device 22 at the clamped gate-source voltage. The short-circuit time is the maximum withstanding time at a given gate-source voltage, which is defined from the datasheet of the devices or can be acquired from the device manufacturers.

The clamping circuit 65 may be configured with a clamping transistor T or any semiconductor switching device which is in series with a clamping resistor R and coupled between the gate G and the source S terminals of the respective power switching device 22, 23. Triggered by the clamping signal, an ohmic connection is established between the gate G and the source S terminals of the concerned power switching device 22, 23 thereby reducing the gate-source-voltage $V_{GS}$.

The voltage sampling unit 62 latches the node voltage and provides an indication of the intermediate node voltage $V_N$ to a second comparator 66 of the upper power switching device 22 or the lower power switching device 23, respectively.

In the second comparator 66, the detected intermediate node voltage $V_N$ is compared with a second threshold $V_{ref2,UP}$, $V_{ref2,LOW}$, respectively. If the intermediate node voltage $V_N$ is out of range, an error signal Error is generated to turn off the power switching device 22, 23. This error signal Error may be latched in a latch 67. The voltage sampling unit 62, the second comparator 66 and the latch 67 form a voltage sampling means.

The range of the reasonable voltage at the intermediate node N is related to the saturation voltage drop of the on-state switching device 22, 23 and can be fully adjusted for the used switching device 22, 23 by considering its data sheet parameters. For example, if the upper switching device 22 is in the on-state, the intermediate node voltage $V_N$ is usually almost the same as the high voltage potential $V_H$ on the DC bus, however, a small margin is suggested to determine the acceptable intermediate node voltage $V_N$, such as $V_{ref2,up}=V_L+(V_H-V_L)*0,9$ (90% of supply voltage). If the intermediate node voltage $V_N$ is lower than Vref2,up, an extensive current through the upper switching device 22 is detected. If the node voltage $V_N$ is higher than the second threshold $V_{ref2,UP}$ in the on-state of the upper switching device 22, no error signal E will be generated. The on-state of the power switching device is indicated by the control signal PWM_UP and PWM_LOW, respectively.

The change of the comparator output creates the pre-defined short pulse from the pulse generator 64. The pulse generator 64 can be a commercially available monostable multivibrator. Since the short circuit only happens during the on state of the power switching device 22, 23. The PWM signal is adopted to control the pulse generator 64 so that pulse of the clamping signal C will be generated only during the on-state of the power switching device 22, 23.

Both the PWM signal PWM_UP,PWM_LOW and the error signal Error are provided to an AND-gate 68 which outputs a common error signal E to initiate a shut-off of the gate driver 4 in case that both too high a value of the transient voltage and too high a value of the voltage drop of the on-state switching device have been detected.

By means of the AND gate 68 for the upper power switching device 22 and the lower power switching device 23, the error signal E is only deployed if the transient voltage sensing unit 61 has detected a high voltage transient voltage on the intermediate node $V_N$ immediately followed by a critical voltage at the intermediate node $V_N$ which is distanced from the high-voltage potential (in case of a switched-on upper power switching device 22) by more than a given voltage threshold determined by the second threshold $V_{ref2,UP}$, $V_{ref2,LOW}$. The second threshold $V_{ref2,UP}$, $V_{ref2,low}$ defines a threshold to detect when e.g. of 10% of the supply voltage preferably of more than 20% of the supply voltage drops across the on-state switching device 22, 23. Therefore, by means of the second comparator 66, it is determined whether which the voltage drop is distanced from the low supply potential $V_L$ (in case of a switched-on lower power switching device 23) or from the high supply potential $V_H$ (in case of a switched-on upper power switching device 22) by more than a given voltage threshold, e.g. of 10% of the supply voltage ($V_H-V_L$) preferably of more than 20% of the supply voltage.

The values of the second threshold $V_{ref2,UP}$, $V_{ref2,LOW}$ of the second comparator 66 may be calibrated depending on the saturation voltage drop across the respective power switching device 22, 23. The actual voltage drop during the static condition is influenced by the device characteristics and the gate-source-voltage $V_{GS}$. Such values can be acquired from the data sheets of the switching devices 22, 23.

The difference between the transient voltage sensing unit 61 and the voltage sampling unit 62 lies in the response speed. The transient voltage sensing unit 61 has a much faster response speed, since a high voltage transient can be quickly detected to identify a potential short-circuit event much before the voltage drop will reach a significant quantity which indicates a short-circuit event.

However, voltage dips or spikes as well as random noise can be introduced to the intermediate node of the concerned phase leg 21 by switching events in other phase legs 21 causing saturation of the power switching devices 22, 23 in the concerned phase leg 21, so that the transient voltage sensing unit 61 may be sensitive to other events in the circuit. This requires the additional criteria of the voltage drop over the on-state switching device.

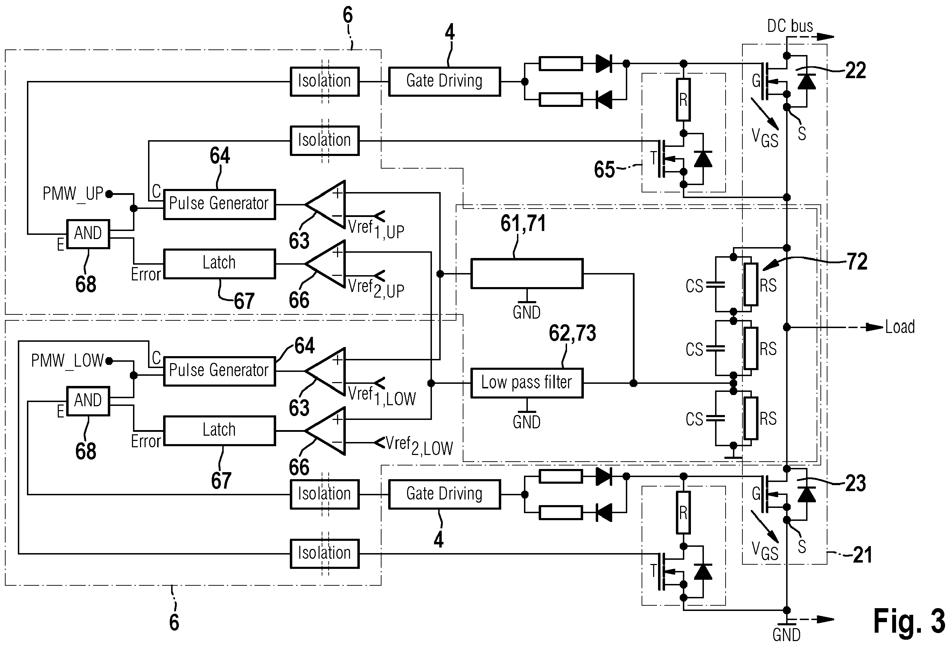

As shown in more detail in Figure 3, the transient voltage sensing unit 61 may be formed with a high-pass filter 71 which receives the intermediate node voltage via a voltage divider 72 for voltage reduction. The voltage divider 72 may be formed by series connection of parallel capacitors Cs and resistors Rs to reduce noise at the input of the transient voltage sensing unit 61. Alternatively or additionally, the voltage sampling unit 62 may be formed with a low-pass filter 73 receiving the divided voltage of the voltage divider 72 to also reduce noise voltage variations for detecting the voltage drop across the switching devices 22, 23.

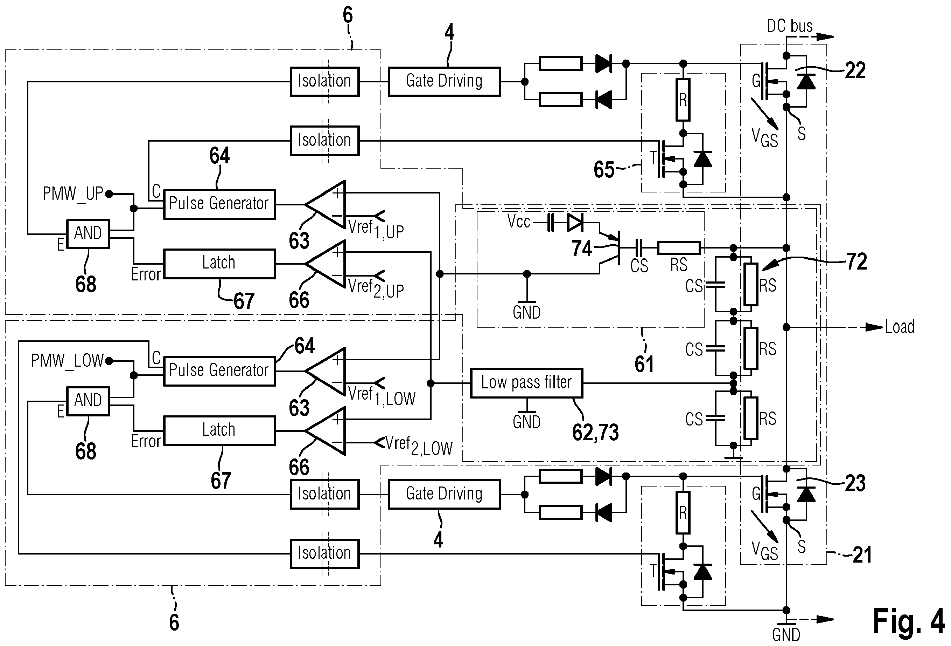

In Figure 4, a specific embodiment with a transient voltage sensing unit 61 is shown. Here the transient voltage sensing unit 61 is coupled via a series connection of a sampling resistor Rs and a sampling capacitor Cs. A bipolar transistor (BJT) 74 is connected as an emitter circuit so that its basis is connected with the series connection. For calibration, the transistor 74 may be turned on when the bias voltage on the resistor is high enough. And then, a pulse is generated in the output of the comparator. The first threshold $V_{ref1,UP}$ is

$$V_{\mathrm{ref,1up}} \geq \frac{V_{BJT}}{R_s C_s}$$

where $V_{BJT}$ is the threshold turn-on voltage of the bipolar transistor 74, which is normally around 0.7V at room temperature. $R_s$ and $C_s$ values can be calibrated according to the real application. The resistor $R_d$ is a damping resistor, which is used to eliminate the potential oscillations in the sampling branch and is relatively small. The first threshold $V_{ref1,UP}$ is within the range of a sampling supply voltage VCC of the circuit. For example, it can be half of the VCC voltage.

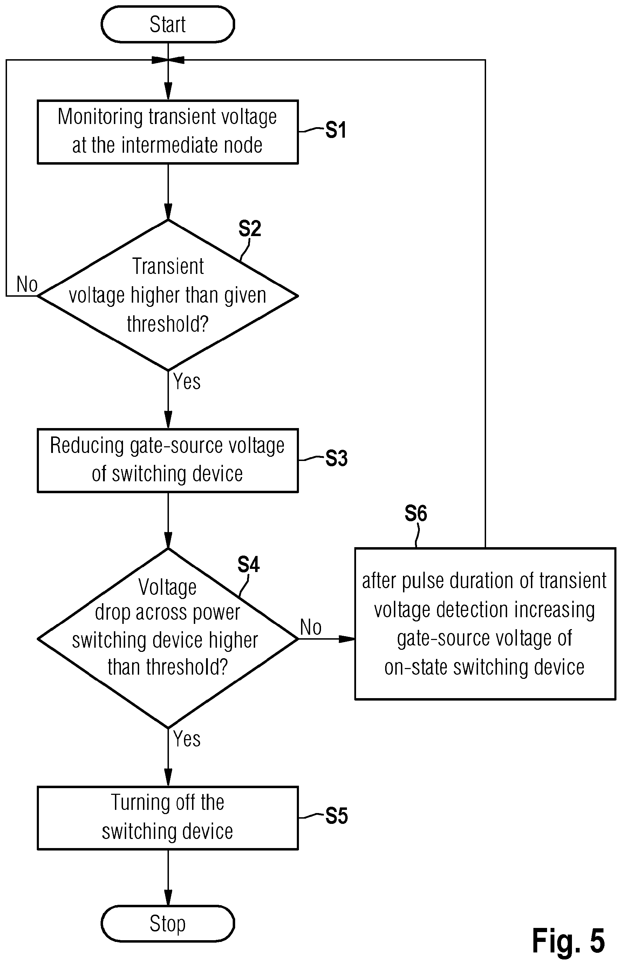

Figure 5 shows a flowchart illustrating the method for operating a power switching device. In step S1, the drain-source-voltage $V_{DS}$ of the power switching devices 22, 23 is monitored by continuously detecting the voltage at the intermediate node N. A transient voltage as a time gradient of the intermediate node voltage is derived.

In step S2, it is checked if the value of the transient voltage at the intermediate node N is higher than a predetermined first threshold value. If positive, the method is continued with step S3, otherwise it is returned to step S1.

In step S3, the gate-source-voltage $V_{GS}$ of at least the on-state power switching device 22, 23 is reduced, e.g. by means of the clamping circuit 65 providing an ohmic coupling between the gate and the source terminals of the respective switching device when activated.

In step S4, it is checked if the value of the drain-source voltage drop of the on-state power switching device 22, 23 is higher than a threshold. This is accomplished by comparing the intermediate node voltage $V_N$ with the second threshold $V_{ref2,UP}$, $V_{ref2,LOW}$ associated with the second comparator 66 of the respective protection unit 6. If positive, the method is continued with step S4, otherwise it is continued with step S6.

In step S5, the power switching device 22, 23 is turned off by the common error signal E by commanding the respective gate driver 4 to stop intermitting switching of the switching device 22, 23, thereby cutting the followed current and protecting the power switching device.

In step S6, the clamping signal C deactivates the clamping circuit 65 after the pulse duration and returns to step S1.

In summary, the above method composes a first fast short-circuit detection by transient voltage sensing for a potential short-circuit event followed by a second slower voltage drop sensing verifying the potential short-circuit event. The difference between the two voltage sensing circuits is the response speed. The transient voltage sensing means 61, 63, 64 has a much faster response speed than the voltage sampling means 62, 66, 67. Therefore, the extremely fast transient voltage sensing can be carried out to identify a potential short-circuit event which then allows to reduce the gate-source voltage $V_{GS}$ of the switching device 22, 23 to gain detection time for the voltage drop detection of the second step. In other words, the high transient voltage sensing is only used to temporarily clamp the gate-source voltage $V_{GS}$ to a lower value in order to limit the saturation current of the power switching device. As a result, the allowable short-circuit time is increased. By adopting the voltage sampling means 62, 66, 67 with enough time to securely detect the short circuit, the noise immunity capability is greatly increased. When the short-circuit event is confirmed, the switching device 22, 23 is turned-off directly. Since the gate-source voltage $V_{GS}$ has been decreased in advance, a soft turn-off is guaranteed and no extra soft turn-off circuit is required.

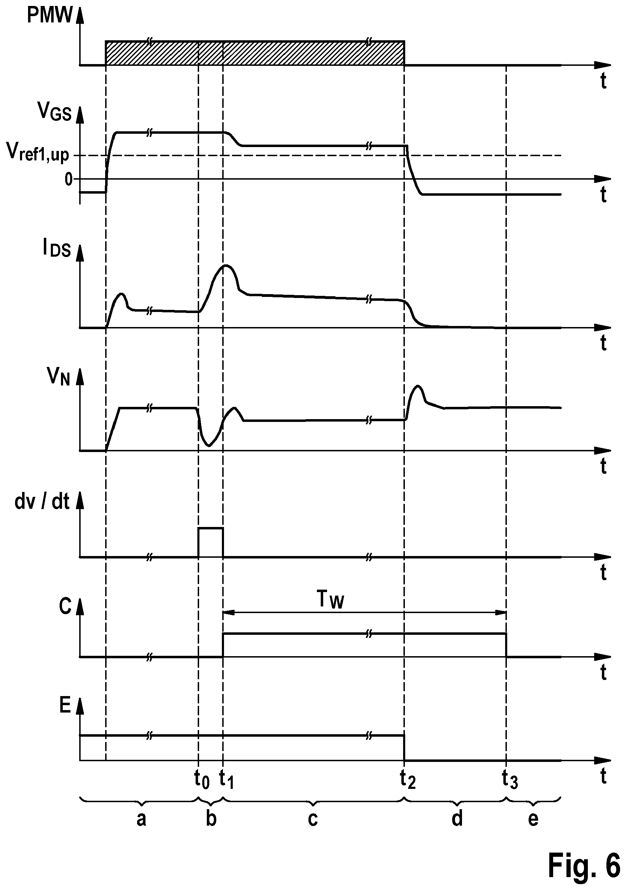

Fig. 6 shows a signal time diagram in a case where a short-circuit event occurs inside the upper switching device 22 of the phase leg 21. The diagram shows the characteristics of the PWM signal, the gate-source voltage $V_{GS}$ of the switching device 22, the drain source current Ids, the intermediate node voltage $V_N$, the clamping signal C and the common error signal E.

Before $t_0$: Upper switching device 22 is in the on-state. The intermediate node voltage equals the high supply potential $V_H$ of the DC bus voltage.

In time interval to-ti, the upper switching device 22 is exposed to the short circuit state.- Due to the dramatically increased current, a voltage dip can be observed at the intermediate node voltage waveform. The first threshold $V_{ref1,UP}$ is pre-defined based on the circuit parameters and device characteristics.

In time interval $t_1$-$t_2$: After receiving the toggle state of the first comparator 63, a pulse-shaped clamping signal C is generated to turn on the clamping circuit 65. The duration of the pulse width is $T_w$, which can be configured adopting the commercially available logic circuits. The selection of $T_w$ depends on the trade-off between the short-circuit detection time and the PWM cycle time. In general, it should be as small as possible to limit the increased power loss over the switching device.

In time interval $t_2$-$t_3$: Short circuit is confirmed by the voltage sampling unit 62. During the on-state, if the voltage at the intermediate node is much lower than the DC bus voltage, the high or the low supply potential $V_H$, $V_L$, the switching device is in the saturation region. Then, the common error signal E is generated to turn off the power switching device 22, 23. The drain-source current $I_{DS}$ returns to zero and the intermediate node voltage equals the respective supply potential again in the steady-state.

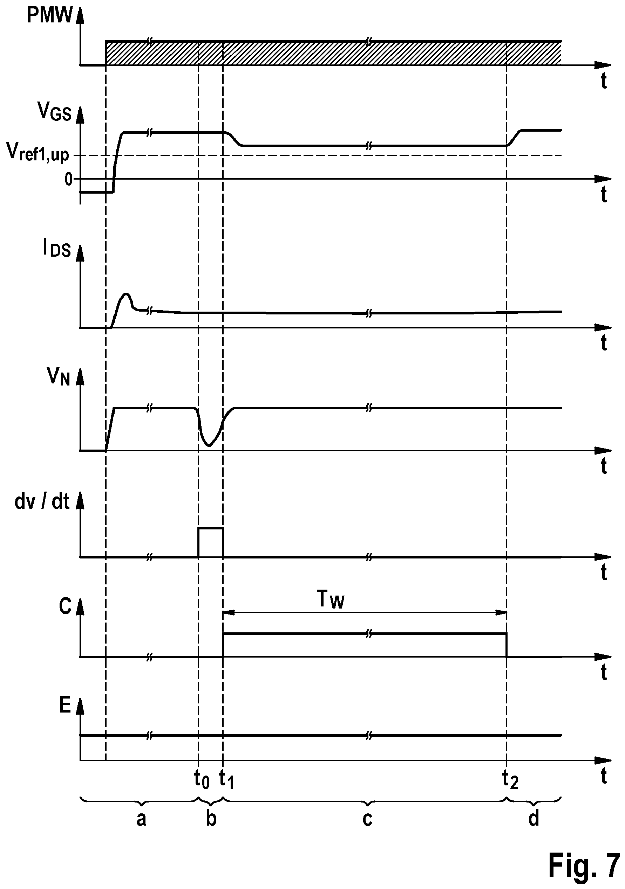

In practice, there may be false triggering of the transient voltage sensing circuit 61 due to the extremely high bandwidth. The false triggering can be eliminated by a delayed checking of the intermediate node voltage. The time sequence is demonstrated in Fig. 7. The only difference happens in stage $t_1$-$t_2$. If there is no common error signal E generated from the voltage sampling unit 62, the clamping circuit 65 will be released again and the gate-source voltage $V_{GS}$ rises to the normal gate driving voltage to reduce the on-state resistance.

As mentioned before, the time sequence is generated by analysing the short-circuit waveform at different time scales. To identify these dynamics, a frequency selective voltage sampling unit 62 can be designed. The approach in selecting the bandwidth BW of the voltage sampling unit 62 is based on the switching speed and short-circuit time of the power switching device 22, 23. Here, the selection of the bandwidth is related to the voltage decreasing time at the intermediate node, based on engineering experience. The bandwidth can be determined by

$$BW \geq \frac{2.5}{t_r}$$

where $t_r$ is the rising time of the original signal. For example, if the voltage dip when a short circuit happens is in the range of 100ns, the bandwidth of the transient voltage sensing unit 61 should be at least 25MHz which should be considered with the selection of the speed of the bipolar transistor 74. At the reduced gate-source voltage condition, if the short-circuit time of the device is 10 $\mu$s, the bandwidth of the voltage sampling unit 62 should be 0.25 MHz. With the above two-step method, the trade-off between the fast response speed and the reliability is achieved.

**Claims**

1. Method for operating a power switching device (22, 23), particularly a wide bandgap power switching device, in a power application, particularly in a converter, comprising the steps of:

    - checking (S2) a transient voltage of or related to a voltage drop across the switching device (22, 23) against a predetermined first threshold ($V_{ref1,UP}$, $V_{ref1,LOW}$) ;
    - reducing (S3) conductivity of the switching device (22, 23) if it is determined that the value of the transient voltage exceeds the predetermined first threshold ($V_{ref1,UP}$, $V_{ref1,LOW}$);
    - after reducing the conductivity, checking (S4) the voltage drop across the switching device (22, 23);
    - deactivating (S5) the operation of the switching device (22, 23) if it is determined that the voltage drop is larger than a predetermined second threshold ($V_{ref2,UP}$, $V_{ref2,LOW}$).

2. Method according to claim 1, wherein reducing conductivity of the switching device (22, 23) is made by selectively turning on a resistance between a gate and a source terminal of the power switching device (22, 23).

3. Method according to claim 1 or 2, wherein the second threshold ($V_{ref2,UP}$, $V_{ref2,LOW}$) is defined depending on the saturation voltage of the power switching device (22, 23), particularly depending on the difference between the gate-source voltage ($V_{DS}$) and the threshold voltage of the power switching device (22, 23), particularly additionally including a given margin of 5-10%.

4. Method according to any of the claims 1 to 3, wherein if it is determined that the voltage drop is lower than a predetermined second threshold ($V_{ref2,UP}$, $V_{ref2,LOW}$), the reduction of the conductivity of the switching device (22, 23) is released.

5. Method according to any of the claims 1 to 4, wherein the switching device (22, 23) is only turned off if it is determined within a given time period that the voltage drop is larger than the predetermined second threshold ($V_{ref2,UP}$, $V_{ref2,LOW}$).

6. Method according to any of the claims 1 to 5, wherein a common error signal (E) is only provided if it is determined that the detection of the transient voltage of the voltage drop across the switching device (22, 23) being larger than the predetermined first threshold ($V_{ref1,UP}$, $V_{ref1,LOW}$) ;and the detection that the voltage depending on the voltage drop across the power switching device (22, 23) being larger than the given second threshold ($V_{ref2,UP}$, $V_{ref2,LOW}$) is made during an on-state condition of the power switching device (22, 23).

7. Protection unit for protecting a power switching device (22, 23) against a short-circuit event, comprising:

    - a transient voltage sensing means (61, 63, 64) configured to check a transient voltage of or related to a voltage drop across the switching device against a predetermined first threshold ($V_{ref1,UP}$, $V_{ref1,LOW}$) ;;
    - a clamping circuit (65) configured to reduce conductivity of the power switching device, particularly for a given time period, if it is determined that the transient voltage of the voltage drop across the switching device (22, 23) is larger than the predetermined first threshold ($V_{ref1,UP}$, $V_{ref1,LOW}$);
    - a voltage sampling unit configured to sample a voltage depending on a voltage drop across the power switching device (22, 23) after reducing the conductivity by the clamping circuit (65);
    - an error signal generating means to provide a common error signal (E) if it is determined that the transient voltage of the voltage drop across the switching device (22, 23) is larger than the predetermined first threshold ($V_{ref1,UP}$, $V_{ref1,LOW}$) ; and if it is determined that a voltage depending on a voltage drop across the power switching device (22, 23) is larger than a given second threshold ($V_{ref2,UP}$, $V_{ref2,LOW}$).

8. Protection unit according to claim 7, wherein the transient voltage sensing means (61, 63, 64) is formed with a transient voltage sensing unit, particularly a high-pass filter, and/or the voltage sampling means is implemented with a voltage sampling unit (62), particularly a low-pass filter.

9. Protection unit according to claim 7 or 8, wherein the error signal generating means is configured to provide the common error signal (E) only if it is determined that the detection of the transient voltage of the voltage drop across the switching device (22, 23) being larger than the predetermined first threshold ($V_{ref1,UP}$, $V_{ref1,LOW}$) ;and the detection that the voltage depending on the voltage drop across the power switching device (22, 23) being larger than the given second threshold ($V_{ref2,UP}$, $V_{ref2,LOW}$) is made during an on-state condition of the power switching device (22, 23).

10. Protection unit according to any of the claims 7 to 9, wherein a first comparator (63) is provided to check if the transient voltage of the voltage drop across the switching device (22, 23) is larger than the first threshold ($V_{ref1,UP}$, $V_{ref1,LOW}$), wherein a pulse generator (64) is provided to generate a pulse for a clamping signal (C) with a predetermined minimum pulse duration for controlling the clamping circuit (65) depending on a result of the checking of the first comparator (63).

11. Power converter comprising:

- At least one phase leg comprising at least two power switching devices (22, 23) in series;
- a protection unit (6) according to any of the claims 7 to 9 for each of the power switching devices (22, 23);
- a gate driver (4) for each of the power switching devices (22, 23) configured to control the power switching devices (22, 23) according to a given switching control scheme and to deactivate switching of the respective power switching device (22, 23) depending on the common error signal (E).

12. Protection unit according to claim 11, wherein the transient voltage sensing means and the voltage sampling means are coupled with an intermediate node between two of the power switching devices (22, 23).

13. Power onverter according to claim 11 or 12, wherein the transient voltage sensing unit (61) of the transient voltage sensing means and the voltage sampling unit (62) of the voltage sampling means are shared for each of the power switching devices (22, 23) of one phase leg.

Fig. 1

EP 4 187 787 A1

**Fig. 2**

Fig. 3

EP 4 187 787 A1

Fig. 4

EP 4 187 787 A1

**Fig. 5**

Fig. 6

Fig. 7

Europäisches
Patentamt

European
Patent Office

Office européen
des brevets

**EUROPEAN SEARCH REPORT**

Application Number

EP 21 21 0742

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2021/098982 A1 (LI HE [US] ET AL) 1 April 2021 (2021-04-01) | 1-12 | INV. H03K17/082 |
| Y | * paragraph [0017] – paragraph [0025]; figures 1-3 * <br> * paragraph [0027] – paragraph [0035] * <br> * paragraph [0036] – paragraph [0042] * <br> * paragraph [0003] – paragraph [0005] * <br> ----- | 13 | |
| Y | US 9 899 999 B2 (KK WIND SOLUTIONS AS [DK]) 20 February 2018 (2018-02-20) | 13 | |
| A | * column 6, line 40 – line 51; claim 1; figure 4 * <br> * column 5, line 50 – line 67 * <br> * column 6, line 1 – line 2 * <br> ----- | 1-12 | |

TECHNICAL FIELDS
SEARCHED      (IPC)

H03K

The present search report has been drawn up for all claims

| Place of search | Date of completion of the search | Examiner |
|---|---|---|
| The Hague | 29 April 2022 | O'Reilly, Siobhan |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

 .....................................................................................
& : member of the same patent family, corresponding
document

EPO FORM 1503 03.82 (P04C01)

## EP 4 187 787 A1

## ANNEX TO THE EUROPEAN SEARCH REPORT
## ON EUROPEAN PATENT APPLICATION NO.

EP 21 21 0742

29-04-2022

| Patent document cited in search report | | Publication date | Patent family member(s) | | Publication date |
|---|---|---|---|---|---|
| US 2021098982 | A1 | 01-04-2021 | NONE | | |
| US 9899999 | B2 | 20-02-2018 | CN | 105191130 A | 23-12-2015 |
| | | | CN | 109905109 A | 18-06-2019 |
| | | | DK | 177863 B1 | 13-10-2014 |
| | | | DK | 2979361 T3 | 12-08-2019 |
| | | | EP | 2979361 A2 | 03-02-2016 |
| | | | US | 2016036430 A1 | 04-02-2016 |
| | | | WO | 2014154221 A2 | 02-10-2014 |

EPO FORM P0459

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **V. JOHN et al.** Fast-clamped short-circuit protection of IGBT's. *IEEE Transactions on Industry Applications,* March 1999, vol. 35 (2), 477-486
- **R. CHOKHAWALA et al.** IGBT fault current limiting circuit. *Conference Record of the 1993 IEEE Industry Applications Conference Twenty-Eighth IAS Annual Meeting,* 1993, vol. 2, 1339-1345
- **P. HOFSTETTERET.** Applying the 2D-Short Circuit Detection Method to SiC MOSFETs including an advanced Soft Turn Off. *PCIM Europe 2018; International Exhibition and Conference for Power Electronics, Intelligent Motion, Renewable Energy and Energy Management,* 2018, 1-7

- **S. YUVARAJAN et al.** Performance analysis and signal processing in a current sensing power MOSFET (SENSEFET). *Conference Record of the 1991 IEEE Industry Applications Society Annual Meeting,* 1991, vol. 2, 1445-1450
- **K. HAN et al.** 1.2-kV 4H-SiC SenseFET With Monolithically Integrated Sensing Resistor. *IEEE Electron Device Letters,* March 2020, vol. 41 (3), 437-440